# EUROPÄISCHE PATENTSCHRIFT

(11) **EP 3 248 446 B1**
(45) Veröffentlichungstag und Bekanntmachung des Hinweises auf die Patenterteilung: **01.07.2020**
(21) Anmeldenummer: 15816433.5
(22) Anmeldetag: 16.12.2015
(51) Int. Cl.: H05K 7/20

(54) **KÜHLEINRICHTUNG**
COOLING DEVICE
DISPOSITIF DE REFROIDISSEMENT

(30) Priorität: 23.01.2015 DE 102015201137
(43) Veröffentlichungstag der Anmeldung: 29.11.2017
(73) Patentinhaber: Robert Bosch GmbH, 70442 Stuttgart (DE)
(72) Erfinder: STILLIG, Javier, 70619 Stuttgart (DE)
(86) Internationale Anmeldenummer: PCT/EP2015/079942
(87) Internationale Veröffentlichungsnummer: WO 2016/116228

(56) Entgegenhaltungen:
- DE-C1- 19 804 904
- US-B1- 6 330 153

## Beschreibung

### Stand der Technik

Die Erfindung betrifft eine Kühleinrichtung für in einem Gehäuse angeordnete wärmeerzeugende Bauteile nach dem Oberbegriff des Anspruchs 1.

Eine Kühleinrichtung nach dem Oberbegriff des Anspruchs 1 ist aus der US 6,330,153 B1 bekannt. Die bekannte Kühleinrichtung ist in Form einer Wärmesenke ausgebildet, wobei auf der Oberfläche der Wärmesenke wärmeerzeugende Bauteile befestigt bzw. angeordnet sind. Innerhalb der Wärmesenke ist ein Strömungskanal für als Kühlmedium dienende Luft vorgesehen, wobei die Anordnung bzw. Ausbildung des Kühlkanals sowie die Dosierung der Menge des Kühlmediums in Abhängigkeit von der Anordnung der wärmeabgebenden Bauteile auf der Wärmesenke erfolgt. Weiterhin kann die Wärmesenke im Bereich der wärmeerzeugenden Bauteile von einem Gehäusedeckel verschlossen sein. Eine weitere Kühleinrichtung ist aus DE19804904 vorbekannt.

Eine weitere Kühleinrichtung ist aus der Praxis bereits zur Kühlung von in einem Schaltschrank angeordneten wärmeerzeugenden Bauteilen bekannt. Bei den Bauteilen kann es sich beispielhaft, und nicht einschränkend, um elektrische bzw. elektronische Bauteile in Form von Trafos, Transistoren oder ähnlichem handeln. Charakteristisch für derartige Bauteile ist es, dass sich diese während des Betriebs unterschiedlich stark erwärmen bzw. eine unterschiedlich große Wärme(menge) erzeugen. Diese Wärmemenge wird innerhalb des Gehäuses an die in dem Gehäuse befindliche Luft abgegeben bzw. abgestrahlt. Zur Kühlung des Gehäuses ist es vorgesehen, beispielsweise mittels eines Ventilators oder ähnlichem, Außenluft in das Gehäuseinnere zu leiten, welche das Gehäuse durchströmt und im Bereich von Austrittsöffnungen aus dem Gehäuse austritt oder aber mittels einer entsprechenden Ventilatoreinrichtung aktiv aus dem Gehäuse abgesaugt wird. Während des Durchströmens der in das Gehäuse von außen eingeleiteten Luft nimmt diese die von den Bauteilen erzeuge Wärme auf. Nachteilig dabei ist, dass je nach Anordnung der einzelnen wärmeerzeugenden Bauteile und der Strömung der Luft innerhalb des Gehäuses Bereiche mit unterschiedlich hohen Temperaturen im Gehäuse entstehen. Insbesondere ist es daher bekannt, den Luftdurchsatz bei einer bestehenden Konfiguration der Bauteile im Gehäuse solange zu erhöhen, bis das hinsichtlich der abgestrahlten Wärme kritischste Bauteil während des Betriebs stets innerhalb seiner zulässigen Betriebstemperatur liegt. Eine hinsichtlich des Energieverbrauchs optimierte Anordnung bzw. Ausbildung der Kühleinrichtung findet dadurch nicht statt. Darüber hinaus müssen bei konventionellen Gehäusen Ansammlungen von relativ vielen wärmeerzeugenden Bauteilen in einem kleinen Bereich innerhalb des Gehäuses vermieden werden, da die Abführung der Wärme aus einem derartigen Gehäusebereich bei einer zentralen Kühlmittelzuführung bzw. Kühlmittelausleitung relativ schwierig bzw. kritisch ist.

### Offenbarung der Erfindung

Ausgehend von dem dargestellten Stand der Technik liegt der Erfindung die Aufgabe zugrunde, ein Kühleinrichtung für in einem Gehäuse angeordnete wärmeerzeugende Bauteile nach dem Oberbegriff des Anspruchs 1 bei einer Verwendung für einem Schaltschrank derart weiterzubilden, dass eine verbesserte Kühlung der Bauteile ermöglicht wird. Insbesondere soll durch die verbesserte Kühlung auf einfache Art und Weise eine Temperaturüberlastung der einzelnen Bauteile vermieden werden. Weiterhin ist es Aufgabe der Erfindung, durch eine optimierte Kühleinrichtung eine verbesserte, insbesondere eine räumlich engere Anordnung von wärmeerzeugenden Bauteilen in dem Gehäuse zu ermöglichen. Auch soll der Energieverbrauch einer derartigen Kühleinrichtung gegenüber dem Stand der Technik trotz ausreichender Kühlwirkung reduziert werden.

Diese Aufgabe wird erfindungsgemäß bei einer Kühleinrichtung für in einem Gehäuse angeordnete wärmeerzeugende Bauteile mit den Merkmalen des Anspruchs 1 gelöst.

Die Erfindung ermöglicht es, jedem wärmeerzeugendem Bauteil genau die Menge an Kühlmedium bzw. Kühlluft zuzuführen, die zu dessen Kühlung erforderlich ist. Damit gelingt es, die Temperaturen aller Bauteile trotz relativ geringem Bedarf an Kühlmedium innerhalb der zulässigen Temperaturgrenzen der Bauteile zu halten. Dadurch ist der Verbrauch an Kühlmedium relativ gering und somit auch die notwendige Energie zum Zuführen des Kühlmediums. Darüber hinaus ermöglicht es eine derartige Ausbildung der Kühleinrichtung, die einzelnen wärmeerzeugenden Bauteile nahezu unabhängig von ihrer erzeugten Wärmemenge innerhalb des Gehäuses anzuordnen. Dadurch wird es möglich, dass die Bauteile mit Blick auf andere erforderliche Randbedingungen, beispielsweise die Erzielung möglichst kurzer elektrischer Verbindungen zwischen den Bauteilen, optimal innerhalb des Gehäuses positioniert werden können. Weiterhin sieht es die Erfindung vor, dass der Strömungskanal Auslassöffnungen für das Kühlmedium aufweist, die den zu kühlenden Bauteilen zugeordnet sind, und die das Kühlmedium in Richtung der zu kühlenden Bauteile leitet.

Vorteilhafte Weiterbildungen der erfindungsgemäßen Kühleinrichtung für in einem Gehäuse angeordnete wärmeerzeugende Bauteile sind in den Unteransprüchen aufgeführt.

In konstruktiver Weiterbildung der Erfindung ist es vorgesehen, dass die Anzahl und/oder Ausrichtung und/oder Querschnitt der Auslassöffnungen der geometrischen Ausbildung des zu kühlenden Bauteils und dessen erzeugter Wärme angepasst sind/ist. Mit anderen Worten gesagt bedeutet dies, dass beispielsweise ein relativ groß bauendes Bauteil oder ein relativ viel Wärme erzeugendes Bauteil eine höhere Anzahl an Auslassöffnungen an dem Verteilermittel aufweist, und/oder dass der Querschnitt der Auslassöffnungen gegenüber anderen Bauteilen vergrößert ist. Auch können die Auslassöffnungen bei einem relativ groß bauenden Bauteil in unterschiedliche Richtungen auf das Bauteil ausgerichtet sein, um dieses möglichst vollflächig bzw. gleichmäßig zu kühlen.

In weiterhin bevorzugter konstruktiver Ausbildung ist es vorgesehen, dass die Verteilermittel ein aus mehreren Kühlrohren und die Kühlrohre mittels Verbindungsmittel miteinander verbindendes, baukastenartig zusammengesetztes Kühlmittelverteilernetz ausbilden, wobei die zu kühlenden Bauteile in Bezug zu einer Montageebene der Bauteile seitlich neben den Kühlrohren angeordnet sind. Eine derartige Ausbildung der Kühleinrichtung ermöglicht es, diese an unterschiedlichste Einsatzzwecke bzw. Einsatzorte individuell anzupassen, wobei im Sinne eines Baukastensystems standardisierte bzw. genormte Elemente zur Ausbildung des Verteilernetzes verwendet werden können. Dadurch lässt sich eine derartige Kühleinrichtung mit relativ geringen Kosten an unterschiedliche Anwendungsfälle anpassen.

In konstruktiver Weiterbildung des zuletzt gemachten Vorschlags ist es vorgesehen, dass die Verteilermittel und die zu kühlenden Bauteile zumindest mittelbar auf einem gemeinsamen Trägerelement angeordnet sind. Dadurch wird eine besonders einfache und übersichtliche Anordnung der Bauteile und der für die Kühleinrichtung erforderlichen Bestandteile auf dem Trägerelement ermöglicht. Ein derartiges Trägerelement kann beispielsweise vor dem Einbau bzw. dem Einsatz in dem Gehäuse vormontiert und als Baueinheit innerhalb des Gehäuses platziert werden.

In einer Weiterbildung der Erfindung, die insbesondere den Verbrauch an Kühlmedium und somit den Energieverbrauch weiter optimiert, ist es vorgesehen, dass in dem Gehäuse Temperaturerfassungsmittel angeordnet sind, und dass die Einrichtung zur Zuführung des Kühlmediums in den Innenraum des Gehäuses in Abhängigkeit der Messwerte der Temperaturerfassungsmittel ansteuerbar ist.

In Industriebetrieben ist es üblich, dass diese über ein Druckluftsystem bzw. ein Druckluftnetz verfügen, mit dem beispielsweise Maschinen betrieben werden können. Erfindungsgemäß ist es in einer Weiterbildung der Erfindung vorgesehen, dieses Druckluftsystem bzw. die im Druckluftsystem vorhandene Druckluft zur Kühlung des Gehäuses bzw. der wärmeerzeugenden Bauteile zu nutzen. Dies erfolgt dadurch, dass das Verteilermittel dazu ausgebildet ist, ggf. unter Zwischenschaltung einer Strömungsdrossel, mit einem Druckluftnetz verbunden zu werden.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: eine vereinfachte perspektivische Innenansicht eines als Schaltschrank dienenden Gehäuses mit einer erfindungsgemäßen Kühleinrichtung und
- Fig. 2: in Draufsicht eine Anordnung von zu kühlenden Bauteilen innerhalb eines Schaltschranks mit einer erfindungsgemäßen Kühleinrichtung.

Gleiche Elemente bzw. Elemente mit gleicher Funktion sind in den Figuren mit den gleichen Bezugsziffern versehen.

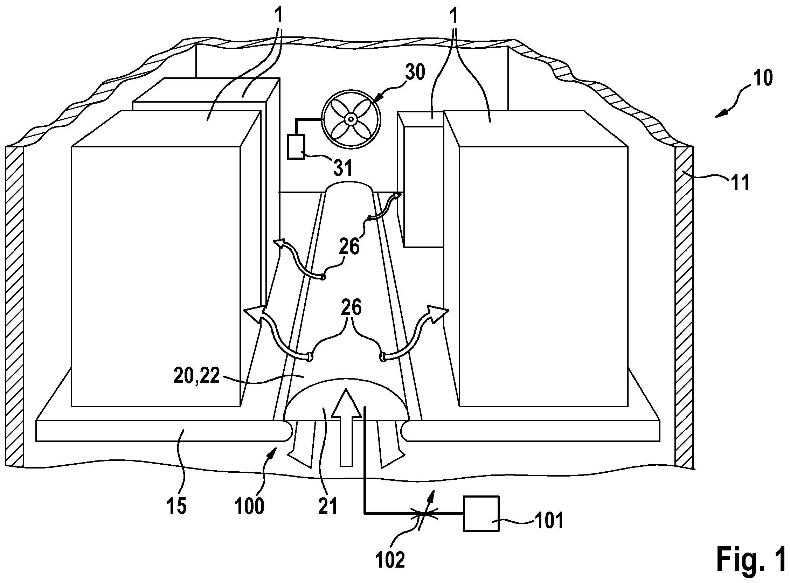

In der Fig. 1 ist stark vereinfacht lediglich bereichsweise und in geschnittener Darstellung ein Gehäuse 11 eines Schaltschranks 10 gezeigt. Das Gehäuse 11 ist in üblicher Art und Weise als geschlossenes Gehäuse 11 ausgebildet und weist beispielsweise eine nicht dargestellte Tür auf, um einen Zugang zu dem Innenraum des Gehäuses 11 zu ermöglichen.

Innerhalb des Gehäuses 11 ist ein plattenförmiges Trägerelement 15 vorgesehen, auf dem eine Vielzahl von zu kühlenden oder auch nicht zu kühlenden Bauteilen 1 angeordnet bzw. befestigt sind. Bei den Bauteilen 1 handelt es sich insbesondere um elektrische oder elektronische Bauteile wie Trafos, Schalteinheiten oder ähnlichem. Das Trägerelement 15 ermöglicht es beispielhaft durch entsprechende Befestigungsmittel, Aufnahmen usw. die Bauteile 1 an verschiedenen Positionen, im dargestellten Ausführungsbeispiel mit Abstand zueinander, auf dem Trägerelement 15 anzuordnen.

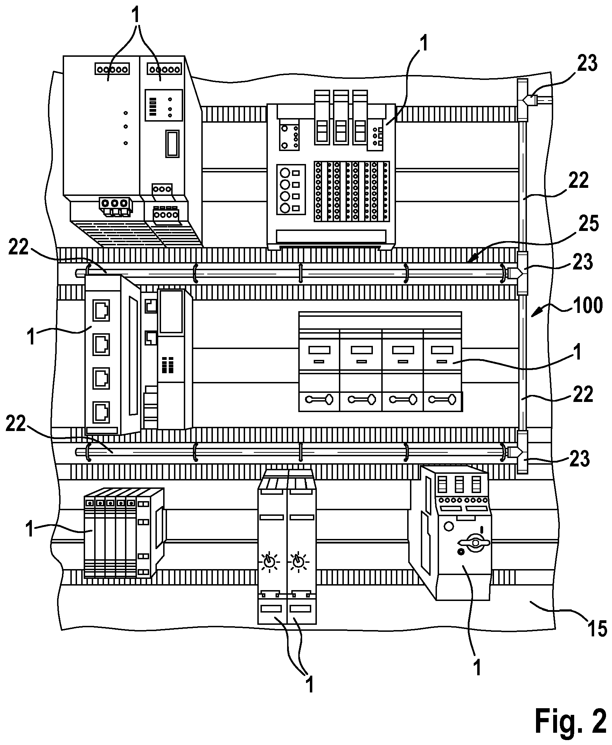

Zumindest einige der Bauteile 1 erzeugen während ihres Betriebs Wärme, die aus dem Gehäuse 11 abgeführt werden muss, um eine Überhitzung der Bauteile 1 und somit deren Beschädigung vorzubeugen. Hierzu dient eine erfindungsgemäße Kühleinrichtung 100, welches eine erste Einrichtung 101 zum Zuführen eines Kühlmediums in den Innenraum des Gehäuses 11 umfasst. Die erste Einrichtung 101 ist beispielhaft in Form eines Druckluftnetzes ausgebildet das, ggf. unter Zwischenschaltung einer (verstellbaren) Drossel 102 oder eines beispielsweise getaktet arbeitenden Pneumatikventils die in dem Druckluftsystem befindliche Druckluft, d.h. Luft, als Kühlmedium in den Innenraum des Gehäuses 11 leitet. Hierzu weist die Kühleinrichtung 100 Verteilermittel 20 auf, die wenigstens einen Strömungskanal 21 für das Kühlmedium (Druckluft) ausbilden. Insbesondere ist der Strömungskanal 21 entsprechend der Zusammenschau der Fig. 1 und 2 innerhalb von im Ausführungsbeispiel einen geschlossenen Querschnitt aufweisenden Kühlrohren 22 ausgebildet, welche entsprechend der Fig. 2 über Verbindungsmittel 23 miteinander verbunden sind, um ein Kühlmittelnetz 25 auszubilden, das der Anordnung der Bauteile 1 innerhalb des Gehäuses 11 bzw. auf dem Trägerelement 15 angepasst ist. Aus den Fig. 1 und 2 ist insbesondere erkennbar, dass die ebenfalls mit dem Trägerelement 15 verbundenen Kühlrohre 22 in Bezug zu einer Montageebene der Bauteile 1 auf dem Trägerelement 15 seitlich bzw. zwischen den Bauteilen 1 angeordnet sind.

Erfindungsgemäß ist es vorgesehen, dass entsprechend der Darstellung der Fig. 1 jedem Bauteil 1, das gekühlt werden muss, wenigstens eine Auslassöffnung 26 in dem Kühlrohr 22 zugeordnet ist, die in Wirkverbindung mit dem zu kühlenden Bauteil 1 angeordnet ist. Insbesondere kann es vorgesehen sein, dass in Abhängigkeit der von dem Bauteil 1 erzeugten Wärme(menge) dem Bauteil 1 eine Vielzahl von Austrittsöffnungen 26 zugeordnet ist, oder dass die Auslassöffnung/en 26 unterschiedliche Querschnitte aufweisen. Ferner sind die Auslassöffnungen 26 an derartigen Positionen an den Kühlrohren 22 angeordnet und so ausgerichtet, dass beim Ausströmen des Kühlmediums aus der/den Auslassöffnung/en 26 das Kühlmedium auf das Bauteil 1 auftrifft.

Die in dem Gehäuse 11 durch die Bauteile 1 erwärmte Luft wird über eine Einrichtung 30 in Form eines Ventilators aus dem Gehäuse 11 ausgeleitet. Ergänzend wird erwähnt, dass es selbstverständlich auch möglich ist, die Einrichtung 30 mit einem Wärmetauscher zu koppeln, um zu vermeiden, dass die aus dem Gehäuse 11 ausgeleitete Luft die Umgebung zu stark erwärmt.

Weiterhin sind innerhalb des Gehäuses 11 Temperaturerfassungsmittel 31 vorgesehen, beispielsweise in Form eines Temperatursensors, der vorzugsweise im Bereich des hinsichtlich der erzeugten Wärme kritischsten Bauteils 1 angeordnet ist. Die Wärmeerfassungsmittel 31 sind beispielsweise derart mit der Drossel 102 bzw. dem Pneumatikventil des Druckluftsystems 101 gekoppelt, dass die Drossel 102 in Abhängigkeit von der erfassten Temperatur des Temperaturerfassungsmittels 1 mehr oder weniger Druckluft in die Kühlrohre 22 einleitet.

Die soweit beschriebene Kühleinrichtung 100 kann in vielfältiger Art und Weise abgewandelt bzw. modifiziert werden, ohne vom Erfindungsgedanken abzuweichen.

## Patentansprüche

1. Kühleinrichtung (100) für in einem Gehäuse (11) angeordnete wärmeerzeugende Bauteile (1), mit einer ersten Einrichtung 101, 102) in Form eines Druckluftnetzes, die dazu ausgebildet ist, Druckluft als Kühlmedium in den Innenraum des Gehäuses (11) einzuleiten und mit einer zweiten Einrichtung (30) in Form eines Ventilators, der dazu ausgebildet ist, die von den wärmeerzeugenden Bauteilen (1) erwärmte Luft aus dem Gehäuse (11) auszuleiten, wobei Kühlrohre (22) als Verteilermittel (20) vorgesehen sind, die wenigstens einen Strömungskanal (21) für die Druckluft ausbilden und dazu ausgebildet sind, mit dem Druckluftnetz verbunden zu werden und die Druckluft in Abhängigkeit der von einem wärmeerzeugenden Bauteil (1) erzeugten Wärme dem wärmeerzeugenden Bauteil (1) bedarfsgerecht zuzuführen,
**dadurch gekennzeichnet, dass**
innerhalb des Gehäuses (11) Temperaturerfassungsmittel (31) vorgesehen sind, wobei in Abhängigkeit von einer erfassten Temperatur des Temperaturerfassungsmittels (31) mehr oder weniger Druckluft in die Kühlrohre (22) eingeleitet wird.

2. Kühleinrichtung nach Anspruch 1,
**dadurch gekennzeichnet,**
**dass** das Verteilermittel (20) einen im Querschnitt zumindest im Wesentlichen geschlossenen Strömungskanal (21) für das Kühlmedium aufweist, der Auslassöffnungen (26) für das Kühlmedium aufweist, die den zu kühlenden Bauteilen (1) zugeordnet sind, wobei die Auslassöffnungen (26) das Kühlmedium in Richtung der zu kühlenden Bauteile (1) leitet.

3. Kühleinrichtung nach Anspruch 2,
**dadurch gekennzeichnet,**
**dass** die Anzahl und/oder Ausrichtung und/oder Querschnitt der Auslassöffnungen (26) der geometrischen Ausbildung des zu kühlenden Bauteils (1) und dessen erzeugter Wärme angepasst sind/ist.

4. Kühleinrichtung nach einem der Ansprüche 1 bis 3,
**dadurch gekennzeichnet,**
**dass** die Verteilermittel (20) ein aus mehreren Kühlrohren (22) und die Kühlrohre (22) mittels Verbindungsmittel (23) miteinander verbundenes, baukastenartig zusammengesetztes Kühlmittelverteilernetz (25) ausbilden, wobei die zu kühlenden Bauteile (1) in Bezug zu einer Montageebene der Bauteile (1) auf einem Trägerelement (15) seitlich neben den Kühlrohren (22) angeordnet sind.

5. Kühleinrichtung nach Anspruch 4,
**dadurch gekennzeichnet,**
**dass** die Verteilermittel (20) und die zu kühlenden Bauteile (1) zumindest mittelbar auf einem gemeinsamen Trägerelement (15) angeordnet sind.

6. Kühleinrichtung nach einem der Ansprüche 1 bis 5,
**dadurch gekennzeichnet,**
**dass** die erste Einrichtung (101, 102) in Abhängigkeit der Messwerte der Temperaturerfassungsmittel (31) ansteuerbar ist.

7. Kühleinrichtung nach einem der Ansprüche 1 bis 6,
**dadurch gekennzeichnet,**
**dass** die Verteilermittel (20) ggf. unter Zwischenschaltung einer Strömungsdrossel (102) mit dem Druckluftnetz verbindbar sind.

8. Kühleinrichtung nach einem der Ansprüche 1 bis 7,
**dadurch gekennzeichnet,**
**dass** das Gehäuse (11) ein Schaltschrank (10) ist.

## Claims

1. Cooling device (100) for heat-generating components (1) which are arranged in a housing (11), comprising a first device (101, 102) in the form of a compressed-air network which is designed to conduct compressed air into the interior of the housing (11) as cooling medium, and comprising a second device (30) in the form of a fan which is designed to conduct the air which is heated by the heat-generating components (1) out of the housing (11), wherein cooling pipes (22) are provided as distributor means (20) which form at least one flow duct (21) for the compressed air and are designed to be connected to the compressed-air network and to supply the compressed air to the heat-generating component (1) as required depending on the heat which is generated by a heat-generating component (1),
**characterized in that**
temperature detection means (31) are provided within the housing (11), wherein more or less compressed air is conducted into the cooling pipes (22) depending on a detected temperature of the temperature detection means (31) .

2. Cooling device according to Claim 1,
**characterized**
**in that** the distributor means (20) has a flow duct (21) for the cooling medium, which flow duct is at least substantially closed in cross section and has outlet openings (26) for the cooling medium, which outlet openings are associated with the components (1) to be cooled, wherein the outlet openings (26) conduct the cooling medium in the direction of the components (1) to be cooled.

3. Cooling device according to Claim 2,
**characterized**
**in that** the number and/or orientation and/or cross section of the outlet openings (26) are/is matched to the geometric design of the component (1) to be cooled and the heat generated by it.

4. Cooling device according to one of Claims 1 to 3, **characterized**
**in that** the distributor means (20) form a cooling means distributor network (25) of modular construction which is composed of a plurality of cooling pipes (22) and connects the cooling pipes (22) to one another by means of connecting means (23), wherein the components (1) to be cooled are arranged laterally next to the cooling pipes (22) with respect to a mounting plane of the components (1) on a carrier element (15).

5. Cooling device according to Claim 4,
**characterized**
**in that** the distributor means (20) and the components (1) to be cooled are arranged at least indirectly on a common carrier element (15).

6. Cooling device according to one of Claims 1 to 5, **characterized**
**in that** the first device (101, 102) can be actuated depending on the measurement values of the temperature detection means (31).

7. Cooling device according to one of Claims 1 to 6, **characterized**
**in that** the distributor means (20) can be connected to the compressed-air network, optionally with the interposition of a flow throttle (102).

8. Cooling device according to one of Claims 1 to 7, **characterized**
**in that** the housing (11) is a switchgear cabinet (10).

## Revendications

1. Dispositif de refroidissement (100) destiné à des composants générateurs de chaleur disposés (1) dans un boîtier (11), ledit dispositif de refroidissement comprenant un premier dispositif (101, 102) se présentant sous la forme d'un réseau d'air comprimé et conçu pour introduire de l'air comprimé comme milieu de refroidissement dans l'espace intérieur du boîtier (11) et un deuxième dispositif (30) se présentant sous la forme d'un ventilateur et conçu pour évacuer du boîtier (11) l'air chauffé par les composants générateurs de chaleur (1), des tubes de refroidissement (22) étant prévus comme moyens de distribution (20), lesquels forment au moins un conduit d'écoulement (21) destiné à l'air comprimé et sont conçus pour être connectés au réseau d'air comprimé et pour amener l'air comprimé au composant générateur de chaleur (1) selon les besoins en fonction de la chaleur générée par un composant générateur de chaleur (1),
**caractérisé en ce que**
des moyens de détection de température (31) sont prévus à l'intérieur du boîtier (11), plus ou moins d'air comprimé étant introduit dans les tubes de refroidissement (22) en fonction d'une température détectée du moyen de détection de température (31).

2. Dispositif de refroidissement selon la revendication 1,
**caractérisé en ce que**
le moyen de distribution (20) comporte un conduit d'écoulement (21), destiné au fluide de refroidissement, qui est au moins sensiblement fermé en coupe transversale et qui comporte des ouvertures de sortie (26), destinées au milieu de refroidissement, qui sont associées aux composants (1) à refroidir, les ouvertures de sortie (26) dirigeant le milieu de refroidissement en direction des composants (1) à refroidir.

3. Dispositif de refroidissement selon la revendication 2,
**caractérisé en ce que**
le nombre et/ou l'orientation et/ou la section des ouvertures de sortie (26) sont adaptés à la conception géométrique du composant (1) à refroidir et à sa chaleur générée.

4. Dispositif de refroidissement selon l'une des revendications 1 à 3,
**caractérisé en ce que**
les moyens de distribution (20) forment un réseau de distribution de milieu de refroidissement (25) qui est composé de manière modulaire d'une pluralité de tubes de refroidissement (22) et qui relie les tubes de refroidissement (22) entre eux à l'aide de moyens de liaison (23), les composants (1) à refroidir étant disposés latéralement à côté des tubes de refroidissement (22) sur un élément de support (15) par rapport à un plan de montage des composants (1).

5. Dispositif de refroidissement selon la revendication 4,
**caractérisé en ce que**
les moyens de distribution (20) et les composants (1) à refroidir sont disposés au moins indirectement sur un élément de support commun (15).

6. Dispositif de refroidissement selon l'une des revendications 1 à 5,
**caractérisé en ce que**
le premier dispositif (101, 102) peut être commandé en fonction des valeurs de mesure des moyens de détection de température (31).

7. Dispositif de refroidissement selon l'une des revendications 1 à 6,
**caractérisé en ce que**
les moyens de distribution (20) peuvent être reliés au réseau d'air comprimé, éventuellement avec interposition d'un restricteur d'écoulement (102).

8. Dispositif de refroidissement selon l'une des revendications 1 à 7,
**caractérisé en ce que**
le boîtier (11) est une armoire de commande (10).
